# EUROPEAN PATENT SPECIFICATION

(11) **EP 3 990 678 B1**
(45) Date of publication and mention of the grant of the patent: **29.10.2025**
(21) Application number: 19935416.8
(22) Date of filing: 25.06.2019
(51) Int. Cl.: C23C 16/455, H01J 37/32, C23C 16/452

(54) **PLASMA IN A SUBSTRATE PROCESSING APPARATUS**
PLASMA IN EINER SUBSTRATVERARBEITUNGSVORRICHTUNG
PLASMA DANS UN APPAREIL DE TRAITEMENT DE SUBSTRAT

(43) Date of publication of application: 04.05.2022
(73) Proprietor: Picosun Oy, 02150 Espoo (FI)
(72) Inventor: HOLM, Niklas, 02430 Masala (FI)
(74) Representative: Espatent Oy
(86) International application number: PCT/FI2019/050494
(87) International publication number: WO 2020/260743

(56) References cited:
- EP-A1- 2 765 217
- WO-A1-02/062114
- WO-A1-02/062115
- WO-A1-2015/031447
- WO-A2-2006/037991
- DE-A1- 3 610 298
- US-A- 4 909 914
- US-A- 4 911 805
- US-A1- 2003 141 178
- US-A1- 2009 223 939
- US-A1- 2014 165 911

## Description

### FIELD OF THE INVENTION

The present invention generally relates to substrate processing methods and apparatus. More particularly, but not exclusively, the invention relates to plasma-enhanced atomic layer deposition (ALD) reactors.

### BACKGROUND OF THE INVENTION

This section illustrates useful background information without admission of any technique described herein representative of the state of the art. The described reactor structure can however be better understood, for example, by considering the granted patent US 9,095,869 B2.

In chemical deposition methods, such as atomic layer deposition (ALD), plasma can be used to provide required additional energy for surface reactions. The use of a plasma source, however, may cause certain requirements or specific problems for the deposition reactor. One such problem is that reactive species in plasma have a limited lifetime.

WO2006037991A2 discloses a microwave plasma apparatus with vorticular gas flow. A gas inlet manifold is provided at the top of the reaction tub, which is formed so as to introduce plasma gas in a swirled manner, that is, in the form of a vortex. This prevents overheating of the reaction tube. EP2765217A1 discloses a remote plasma generation apparatus that can enhance plasma processing efficiency by centralizing remote plasma to a processing object. DE3610298A1 relates to an apparatus for controlling a flow of fine particles. WO02062115A1 relates to a plasma installation. In a preferred embodiment, during the operation of the plasma installation, both the plasma jet and the electrical voltage applied to a substrate electrode are pulsed, and/or a pressure drop is maintained between the inside of the plasma jet source and the inside of a chamber, in the direction of the plasma jet source to the chamber. WO02062114A relates to a plasma system with an inductively coupled high-frequency plasma beam source and a method for producing a functional coating on a substrate.

### SUMMARY

It is an object of certain embodiments of the invention to cope with the limited lifetime of plasma or at least to provide an alternative to existing technology.

According to a first example aspect of the invention there is provided a substrate processing apparatus according to claim 1.

In certain embodiments, the apparatus comprises a plasma source. In certain embodiments, the plasma source is positioned upstream of the inlet part. In certain embodiments, the plasma source comprises a plasma source tube (a tube travelling across the plasma source). In certain embodiments, plasma species is generated within the plasma source tube. In certain embodiments, the inlet part and the plasma source tube are concentric parts.

In certain embodiments, the apparatus comprises the plasma in-feed line in between the plasma source and the deposition target to introduce plasma species into the reaction chamber for the deposition target.

In certain embodiments, the deposition target is positioned within the reaction chamber. In certain embodiments, the deposition target is a substrate. In certain embodiments, the deposition target is a batch of substrates. In certain embodiments, the substrate is a wafer. In certain embodiments, the substrates in the batch of substrates are vertically oriented.

In certain embodiments, the inlet part is positioned between the plasma source and the reaction chamber. In certain embodiments, the plasma source is a remote plasma source. In certain embodiments, the plasma source is positioned on the outside of the reaction chamber.

In certain embodiments, the plasma species comprises gaseous plasma. In certain embodiments, the plasma species comprises radicals. In certain embodiments, the plasma species comprises ions.

In certain embodiments, the inlet part is centrally positioned within the plasma in-feed line. According to the invention, the inlet part has a narrower inner diameter than the other parts / remaining parts in the plasma in-feed line. In certain embodiments, the plasma in-feed line has at its narrowest inner diameter within the inlet part. In certain embodiments, the inlet part provides for the narrowest channel width of the plasma in-feed line.

In certain embodiments, the inlet part is in the form of an inlet liner with a holder for the inlet liner. According to the invention, the inlet liner is a tubular item. In certain embodiments, the inlet liner is transparent to visible light. In certain embodiments, the inlet liner is chemically inert. In certain embodiments, the inlet liner (inner tube) is electrically insulating. In certain embodiments, inlet part comprises an inner tube surrounded by an outer tube or outer part. In certain embodiments, the inner tube and the outer tube are concentric parts. In certain embodiments, the inner tube and the outer tube have a ring-like cross-section. In certain embodiments, the inner tube and the outer tube are tightly fitted against each other. In certain embodiments, the outer part or outer tube forms a holder for the inner tube. In certain embodiments, the outer part or outer tube is electrically conductive. In certain embodiments, the outer part or outer tube is applied with an appropriate electric potential, such as system ground. In certain embodiments, the inlet part is attached in between pipe portions.

In certain embodiments, the inlet part is a removable part. In certain embodiments, the inner tube is a removable part. In certain embodiments, the inlet part provides the plasma in-feed line with a sudden constriction, or a stricture, to enhance gas velocity. In certain embodiments, the inlet part provides the plasma in-feed line with a stepwise narrowing of flow path. In certain embodiments, the inlet part is followed by an expansion space expanding towards the reaction chamber. In certain embodiments, the flow path from the plasma source to the reaction chamber undergoes a stepwise expansion (or widening) at an interface or in connection with an interface between the inlet part and the expansion space. In certain embodiments, the inlet part is a non-actuated part, for example, not a valve. In certain embodiments, the inlet part is a passive part (i.e., non-active part). In certain embodiments, the cross-sectional area of the plasma in-feed line (expansion space) immediately after (or downstream of) the inlet part is larger than the cross-sectional area of the plasma in-feed line (plasma source tube) immediately before (or upstream of) the inlet part.

In certain embodiments, the reaction chamber is surrounded by a vacuum chamber.

In certain embodiments, plasma reactant gas is excited by RF (radio frequency) radiation. In certain embodiments, plasma reactant gas is excited by microwave radiation. In certain embodiments, the plasma reactant gas is fed into a plasma source tube without injecting. In certain embodiments, the plasma reactant gas optionally together with carrier and/or inert gas is fed into a plasma source tube without injecting the gas into the plasma source tube. Accordingly, the plasma reactant gas optionally together with carrier and/or inert gas is conducted into the plasma source tube along a (regular) pipeline (i.e., without special injection arrangements). The pipeline in certain embodiments comprises at least one valve (or plasma reactant pulsing valve).

In certain embodiments, the plasma in-feed line comprises a vertical plasma source tube comprising a plasma formation section. In certain embodiments, the plasma in-feed line goes along a vertical path through the plasma formation section and the constriction.

In certain embodiments, the apparatus comprises a converging nozzle arrangement or a converging-diverging nozzle arrangement to speed up gas velocity.

In certain embodiments, the apparatus is configured to perform sequential self-saturating surface reactions on a substrate surface in the reaction chamber. In certain embodiments, the apparatus is configured to apply plasma-assisted atomic layer deposition.

According to a second example aspect of the invention there is provided a method according to claim 8.

In certain embodiments, a jet nozzle inlet liner is provided. According to the invention, the jet nozzle inlet liner is a tubular item and the inner diameter of the part is essentially smaller than the inner diameters of other parts of the gas introduction. It has been observed that gas velocity increases inside the part since its cross section is smaller than the plasma source tube and the reaction chamber. The increase may be based on, for example, a choked flow effect. It has also been observed that gas velocity is not only increased inside the inlet liner but also at a relatively long distance downstream the inlet liner, and even close to the deposition target. An obtained jet flow is minimizing the delivery time from plasma source to deposition target. The jet flow in certain embodiments is in contact with surrounding gas and thus a contact surface area with solid material is minimal. This further improves reactive species (or plasma species) delivery to the deposition target since the average lifetime of reactive species is getting longer.

According to the invention, the inlet part comprises a tubular part with a smaller inner diameter than the in-feed line (or with a smaller inner diameter than the plasma source tube). In certain embodiments, the inlet part comprises a tubular part that is chemically inert. In certain embodiments, the inlet part comprises a tubular part that is electrically insulating. In certain embodiments, the inlet part comprises an outer part or tube housing an inner tube.

In certain embodiments, the method comprises:
surrounding the reaction chamber by a vacuum chamber.

In certain embodiments, the method comprises:
performing sequential self-saturating surface reactions on a substrate surface in the reaction chamber.

Different non-binding example aspects and embodiments have been illustrated in the foregoing. The above embodiments are used merely to explain selected aspects or steps that may be utilized in implementations of the present invention. Some embodiments may be presented only with reference to certain example aspects. It should be appreciated that corresponding embodiments apply to other example aspects as well. Any appropriate combinations of the embodiments may be formed.

### BRIEF DESCRIPTION OF THE DRAWINGS

The invention will now be described, by way of example only, with reference to the accompanying drawings, in which:
- Fig. 1: shows an apparatus in accordance with certain embodiments;
- Fig. 2: shows an apparatus in accordance with further embodiments;
- Fig. 3: shows the apparatus of Fig. 2 in a loading position;
- Fig. 4: shows an inlet part in accordance with certain embodiments; and
- Fig. 5: shows simulation results of gas velocity in an apparatus in accordance with certain embodiments;
- Fig. 6: shows a schematic drawing of an apparatus with a converging nozzle arrangement in accordance with certain example embodiments; and
- Fig. 7: shows a schematic drawing of an apparatus with a converging-diverging nozzle arrangement in accordance with certain example embodiments.

### DETAILED DESCRIPTION

In the following description, Atomic Layer Deposition (ALD) technology is used as an example.

The basics of an ALD growth mechanism are known to a skilled person. ALD is a special chemical deposition method based on sequential introduction of at least two reactive precursor species to at least one substrate. A basic ALD deposition cycle consists of four sequential steps: pulse A, purge A, pulse B and purge B. Pulse A consists of a first precursor vapor and pulse B of another precursor vapor. Inactive gas and a vacuum pump are typically used for purging gaseous reaction by-products and the residual reactant molecules from the reaction space during purge A and purge B. A deposition sequence comprises at least one deposition cycle. Deposition cycles are repeated until the deposition sequence has produced a thin film or coating of desired thickness. Deposition cycles can also be either simpler or more complex. For example, the cycles can include three or more reactant vapor pulses separated by purging steps, or certain purge steps can be omitted. Or, as for plasma-assisted ALD, for example PEALD (plasma-enhanced atomic layer deposition), discussed herein one or more of the deposition steps can be assisted by providing required additional energy for surface reactions through plasma in-feed, or one of the reactive precursors can be substituted by plasma energy, the latter leading to single precursor ALD processes. Accordingly, the pulse and purge sequence may be different depending on each particular case. The deposition cycles form a timed deposition sequence that is controlled by a logic unit or a microprocessor. Thin films grown by ALD are dense, pinhole free and have uniform thickness.

As for substrate processing steps, the at least one substrate is typically exposed to temporally separated precursor pulses in a reaction vessel (or chamber) to deposit material on the substrate surfaces by sequential self-saturating surface reactions. In the context of this application, the term ALD comprises all applicable ALD based techniques and any equivalent or closely related technologies, such as, for example the following ALD sub-types: MLD (Molecular Layer Deposition), plasma-assisted ALD, for example PEALD (Plasma Enhanced Atomic Layer Deposition) and photon-enhanced Atomic Layer Deposition (known also as flash enhanced ALD or photo-ALD).

However, the invention is not limited to ALD technology, but it can be exploited in a wide variety of substrate processing apparatuses, for example, in Chemical Vapor Deposition (CVD) reactors, or in etching reactors, such as in Atomic Layer Etching (ALE) reactors.

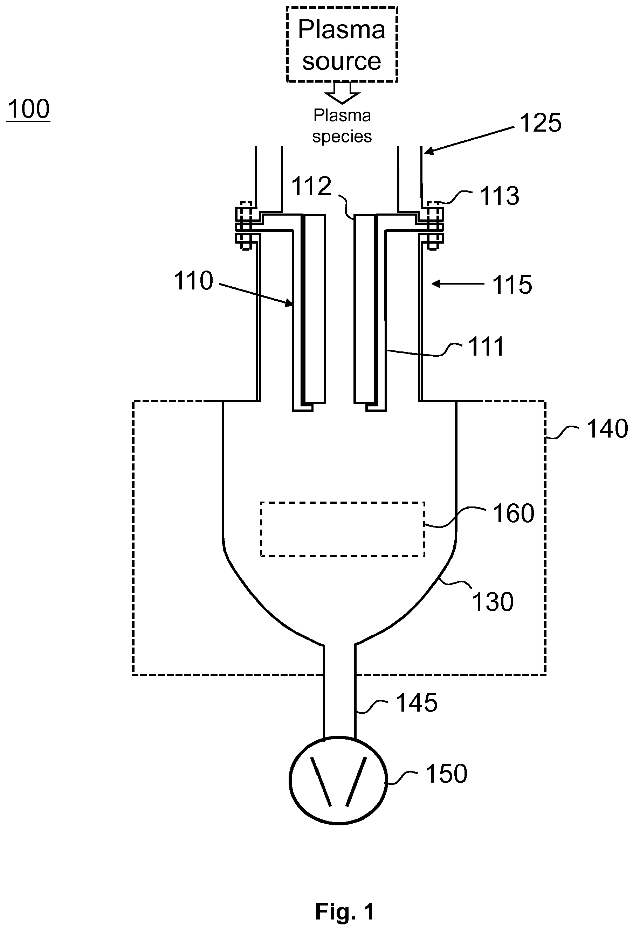

Fig. 1 shows an apparatus 100 in accordance with certain embodiments. The apparatus 100 is a substrate processing apparatus which may be, for example, a plasma-assisted ALD reactor. The apparatus comprises a reaction chamber 130 and an in-feed line (or in-feed arrangement) 115 to introduce plasma, for example gaseous plasma, for a deposition target 160 positioned in the reaction chamber 130. The deposition target 160 may be a substrate (or wafer) or a batch of substrates.

The apparatus 100 further comprises an exhaust line 145 leading to a vacuum pump 150. The reaction chamber 130 may be in the general form of a cylinder that is rounded at its bottom, or it may be adopted to any other substrate shape. The exhaust line 145 in certain embodiments is positioned in the rounded bottom of the reaction chamber 130. The vacuum pump 150 provides a vacuum for the reaction chamber 130. The apparatus in certain embodiments comprises an outer chamber, a vacuum chamber 140 around the reaction chamber 130. Inactive shield gas may be fed into an intermediate space in between the vacuum chamber 140 and the reaction chamber 130. The pressure within the intermediate space is kept, by pumping, on a higher level compared to prevailing pressure within the reaction chamber 130. The same vacuum pump 150 or another pump may be used to arrange an outgoing flow (of inactive gas) from the intermediate space.

The plasma in-feed 115 into the reaction chamber 130 is arranged from a plasma source, or a remote plasma source. The in-feed occurs from the top side of the reaction chamber 130. Plasma species travel from plasma source tube 125 in a downward direction. In certain embodiments, the plasma source tube 125 forms part of the in-feed line 115. The in-feed line 115 comprises an inlet part 110 that is configured to speed up gas velocity. In certain embodiments, the inlet part 110 is positioned downstream of the plasma source tube 125. In certain embodiments, the inlet part 110 is a tubular part having a narrower inner diameter than the plasma source tube 125 preceding the inlet part 110. In certain embodiments, the plasma source tube 125 forms part of the plasma source. In certain embodiments, there may be another pipe portion in between the plasma source tube 125 and the inlet part 110.

When the plasma species enters the inlet part 110 its velocity increases. The delivery time to the deposition target 160 is respectively reduced.

The inlet part 110 may be formed of an outer part or tube 111 housing an inner tube 112. The outer tube 111 may be made of metal, for example. An example material is aluminum or steel. It may be an electrically conductive part. The inner tube 112 may be chemically inert. In certain embodiments, the inner tube 112 is made of quartz. In certain embodiments, the inner tube 112 is made of sapphire. The inner tube 112 may be electrically insulating. The outer tube 111 may comprise an inwardly protruding shape in its bottom portion for the inner tube 112 to rest on. Further, the outer tube 111 may contain an outwardly protruding shape in its top portion for fixing the inlet part 110 in between pipe portions by fixing means 113 or similar. The inner tube 112 may be an inlet liner for the outer tube 111. The inner tube 112 may form a jet nozzle inlet liner.

In certain embodiments, the inlet part 110 has an input opening for receiving the plasma species into inside of the inner tube 112 in a top portion of the inlet part 110. The inner tube 112 provides a straight cylindrical channel for the plasma species to flow downwards until an output opening in a bottom portion of the inlet part 110 outputs the plasma species with the increased velocity from the inside of the inner tube 112 into inside of the reaction chamber 130. In certain embodiments, as shown in Fig. 1, upon outputting the plasma species into inside of the reaction chamber 130 the plasma species experiences a step-like enlargement of the flow path. Accordingly, in certain embodiments, the flow path after the enlargement is sideways limited by the cylindrical wall of the reaction chamber 130.

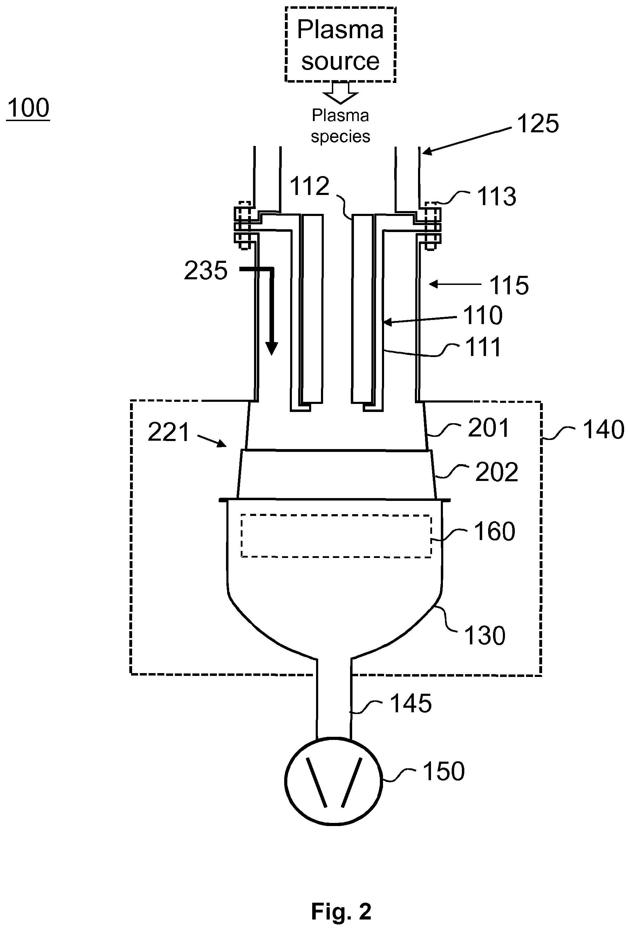

Fig. 2 shows an apparatus 200 in accordance with certain embodiments. The apparatus 200 and its operation generally corresponds to that of apparatus 100.

Therefore, a reference is made to the preceding description. However, in the embodiment shown in Fig. 2, further features relating to substrate loading and unloading is presented.

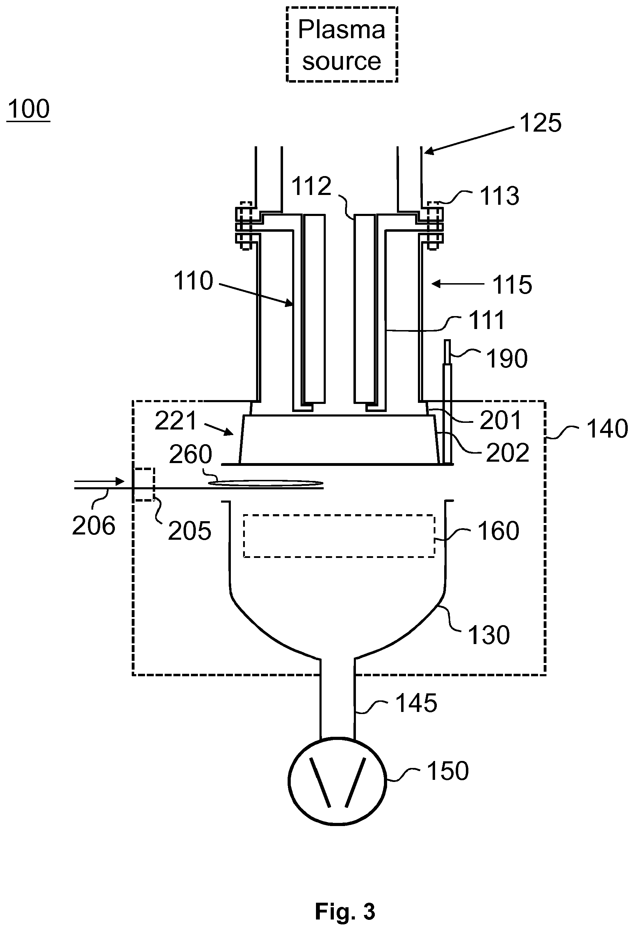

A deformable in-feed part 221 is positioned in between the inlet part 110 and the deposition target 160. The deformable in-feed part 221 has a closed configuration for substrate processing, for example, by plasma-assisted ALD and an open configuration for substrate loading. In the closed configuration, the in-feed part 221 may be in an extended shape, and in the open configuration in a contracted shape. The closed configuration is depicted in Fig. 2 and the open configuration in Fig. 3.

The deformable in-feed part 221 comprises a set of nested sub-parts or ring-like members which are movable to fit within each other. In the embodiment shown in Figs. 2 and 3, the number of sub-parts is two. The sub-parts 201 and 202 form a telescopic structure. In the example embodiment shown in Fig. 2 and 3, the upper sub-part 201 is attached to a wall of the vacuum chamber 140. The attachment may be in a top wall of the vacuum chamber 140 or in another appropriate point depending on the embodiment. In other embodiments, the upper sub-part may be attached to an outlet of the inlet part 110. A gradually widening flow path from the inlet part 110 into inside of the reaction chamber 130 may in that way be provided instead of the step-like enlargement. In certain embodiments, such as shown in Figs. 2 and 3, the lower sub part 202 either closes an interface between the lower sub part 202 and the reaction chamber 130 (or reaction chamber wall) as depicted in Fig. 2 or provides for a loading gap for substrate loading into the reaction chamber 130 as depicted in Fig. 3.

As shown in Fig. 3, a retractable shaft of an elevator 190 is attached to the deformable in-feed part 221 or in connection with it. The elevator 190 operates the deformable in-feed part 221. A substrate 260 (or a batch of substrates) is loaded into the reaction chamber 130 via a loading port 205 by a loader 206 (an end effector, a loading robot or similar) through the loading gap formed by vertically deforming the in-feed part 221 into its open configuration.

The plasma species travels as a vertical flow from the plasma source through the plasma source tube 125 and through the inlet part 110 with an increased velocity to the output opening or outlet of the inlet part 110 and therefrom along the gradually widening flow path to the deposition target 160.

In certain embodiments, a protective inert gas flow 235 is provided in a downward direction around the inlet part 110 (see Fig. 2).

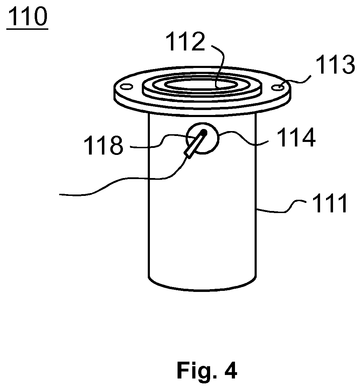

Fig. 4 shows the inlet part 110 in accordance with certain embodiments. The inlet part 110 comprises the outer tube 111 housing the inner tube or inlet liner 112. The inlet part 110 optionally comprises an opening 114 radially extending through the whole outer tube 111 of at least one side (but not through the inner tube 112) for viewing the plasma from a side direction. In certain embodiments, a pressure sensor 118 is positioned within the opening 114.

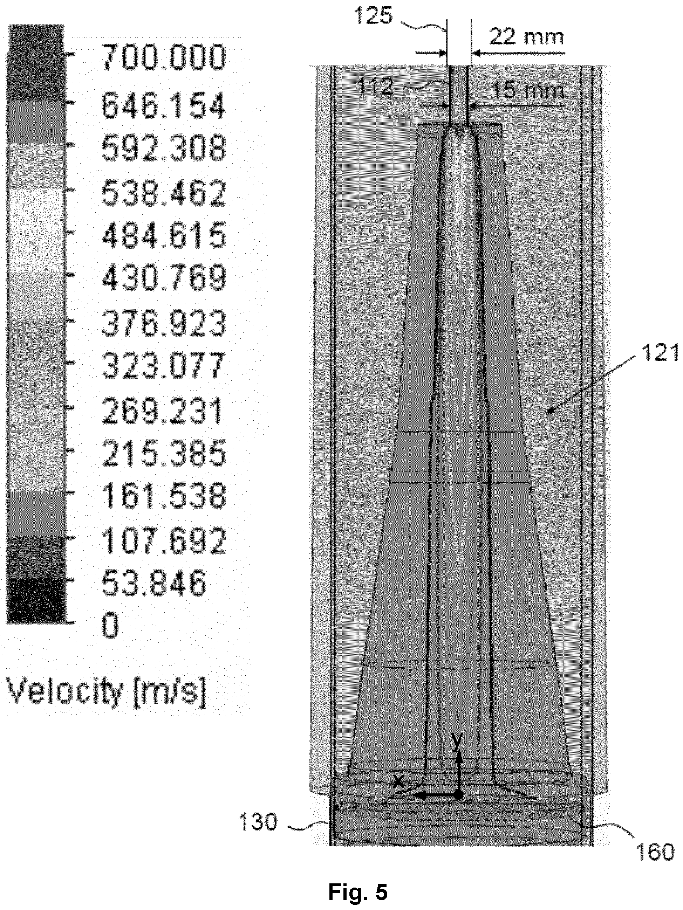

Fig. 5 shows simulation results of gas velocity in an apparatus in accordance with certain embodiments. The apparatus is of the type shown in the preceding Figs. 1-3, especially in Figs. 2-3. Accordingly, the apparatus comprises the plasma source tube 125 followed by the inlet part (with the inner tube 112 shown) with an inner diameter that is narrower than the inner diameter of the tube 125. The inlet part is followed by an expansion volume (part 121, or similar) expanding towards the deposition target 160 in the reaction chamber 130. For the purposes of simulation, the plasma source tube 125 had an inner diameter of 22 mm, and the inner tube 112 an inner diameter of 15 mm. It is observed that gas velocity is not only increased inside the part 112 but also at a relatively long distance downstream the part 112, and even close to the deposition target 160.

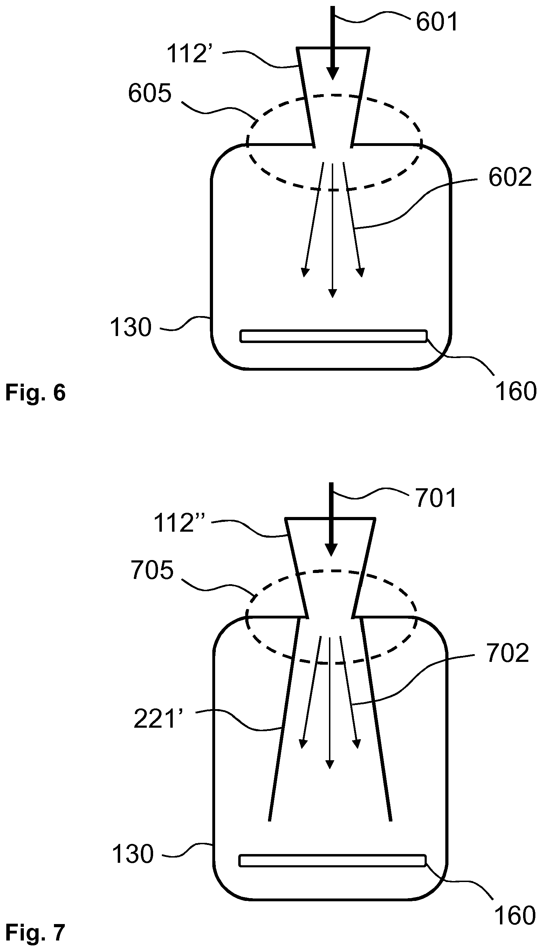

Fig. 6 shows a schematic drawing of an apparatus in accordance with certain further embodiments. In these embodiments, the inlet part 110 (see Figs. 1-4 in the preceding) is implemented by a converging nozzle arrangement 605. In an embodiment as shown in Fig. 6, the plasma reactant (or formed plasma species) enters a nozzle part 112' (as depicted by arrow 601). The nozzle part 112' may be otherwise similar to the inner tube or inlet liner 112 described in the preceding but, instead of a flow channel with an unchanging geometry and diameter, the nozzle part 112' provides a converging channel. As an example, the nozzle part 112' may contain an upside-down placed truncated cone 112' that forms a converging flow channel therein. The gas velocity accelerates within the converging channel provided by the nozzle part 112'. At the reaction chamber end of the nozzle part 112', the flow channel comprises a stepwise widening of the flow channel (flow path). At this point the plasma species is released with an increased velocity towards the deposition target 160 (in the reaction chamber 130) as depicted by arrows 602. The in-feed of non-plasma precursor(s) into the reaction chamber 130 is arranged via another route (i.e., a route not passing through the converging nozzle arrangement 605). In certain embodiments, the in-feed of non-plasma precursor(s) is arranged (downstream of the converging nozzle arrangement 605) from a side or from sides of the reaction chamber 130 whilst the flow direction of the plasma species to the reaction chamber is from the top of the reaction chamber.

Fig. 7 shows a schematic drawing of an apparatus in accordance with certain further embodiments. In these embodiments, instead of the converging nozzle arrangement 605, the apparatus comprises a converging-diverging nozzle arrangement 705. In an embodiment as shown in Fig. 7, the plasma reactant (or formed plasma species) enters a nozzle part 112" (as depicted by arrow 701). The nozzle part 112" may be otherwise similar to the nozzle part 112' but, instead of a mere converging channel provided by part 112', the nozzle part 112" provides a converging channel followed by a diverging (expanding, in volume) channel. In certain embodiments, the converging and diverging channel parts comprise an interface therebetween which provides a stepwise widening of the flow channel (flow path). The stepwise widening is to prevent plasma recombination by collisions to the flow channel side wall(s). As an example, the nozzle part 112" may contain an upside-down placed truncated cone that forms a converging flow channel, and followed by another truncated cone 221' that forms a diverging (expanding) flow channel therein. The gas velocity accelerates within the converging channel provided by the nozzle part 112". At the interface between the converging and diverging channels, the plasma species is released with an increased velocity towards the deposition target 160 (positioned within the reaction chamber 130) as depicted by arrows 702. The in-feed of non-plasma precursor(s) into the reaction chamber 130 is arranged via another route (i.e., a route not passing through the converging-diverging nozzle arrangement 705). In certain embodiments, the in-feed of non-plasma precursor(s) is arranged (downstream of the converging-diverging nozzle arrangement 705) from a side or from sides of the reaction chamber 130 whilst the flow direction of the plasma species to the reaction chamber is from the top of the reaction chamber. With the converging-diverging nozzle arrangement 705 even a supersonic gas jet is possible.

The presented converging nozzle feature and converging-diverging nozzle feature presented in the embodiments shown in Figs. 6 and 7 are applicable in all other presented embodiments. Similarly, features of the other embodiments are applicable in the embodiments shown in Figs. 6 and 7.

Without limiting the scope and interpretation of the patent claims, certain technical effects of one or more of the example embodiments disclosed herein are listed in the following. A technical effect is providing improved reaction species delivery to the deposition target. A further technical effect is forming a chemically resistant barrier layer between metal parts and reactive plasma species.

The foregoing description has provided by way of non-limiting examples of particular implementations and embodiments of the invention a full and informative description of the best mode presently contemplated by the inventors for carrying out the invention. It is however clear to a person skilled in the art that the invention is not restricted to details of the embodiments presented above, but that it can be implemented in other embodiments using equivalent means without deviating from the characteristics of the invention.

Furthermore, some of the features of the above-disclosed embodiments of this invention may be used to advantage without the corresponding use of other features. As such, the foregoing description should be considered as merely illustrative of the principles of the present invention, and not in limitation thereof. Hence, the scope of the invention is defined by the appended patent claims.

## Claims

1. A substrate processing apparatus (100), comprising:
a reaction chamber (130);
a plasma in-feed line (115) to introduce plasma species into the reaction chamber (130) for a deposition target (160), wherein
the plasma in-feed line (115) comprises an inlet part (110) configured to speed up gas velocity;
**characterized in that**, the inlet part (110) comprises a tubular part (112) with a smaller inner diameter than the in-feed line (115).

2. The apparatus of claim 1, wherein the inlet part (110) comprises a tubular part (112) that is chemically inert.

3. The apparatus of any preceding claim, wherein the inlet part (110) comprises a tubular part (112) that is electrically insulating.

4. The apparatus of any preceding claim, wherein the inlet part (110) comprises an outer part or tube (111) housing an inner tube (112).

5. The apparatus of any preceding claim, comprising:
a vacuum chamber (140) surrounding the reaction chamber (130).

6. The apparatus of any preceding claim, comprising:
a converging nozzle (112') or a converging-diverging nozzle (112") to speed up gas velocity.

7. The apparatus of any preceding claim, configured to perform sequential self-saturating surface reactions on a substrate surface in the reaction chamber (130).

8. A method, comprising:
introducing plasma species via a plasma in-feed line (115) into a reaction chamber (130) for a deposition target (160) in a substrate processing apparatus (100); and
speeding up gas velocity within the plasma in-feed line by an inlet part (110), **characterized in that** the inlet part (110) comprises a tubular part (112) with a smaller inner diameter than the in-feed line (115).

9. The method of claim 8, wherein the inlet part (110) comprises a tubular part (112) that is chemically inert.

10. The method of any preceding claim 8-9, wherein the inlet part (110) comprises a tubular part (112) that is electrically insulating.

11. The method of any preceding claim 8-10, wherein the inlet part (110) comprises an outer part or tube (111) housing an inner tube (112).

12. The method of any preceding claim 8-11, comprising:
surrounding the reaction chamber (130) by a vacuum chamber (140).

13. The method of any preceding claim 8-12, comprising:
performing sequential self-saturating surface reactions on a substrate surface in the reaction chamber (130).

## Patentansprüche

1. Substratverarbeitungsvorrichtung (100), umfassend:
eine Reaktionskammer (130);
eine Plasmazufuhrleitung (115) zur Einführung von Plasmaspezien in die Reaktionskammer (130) für ein Abscheidungsziel (160), wobei
die Plasmazufuhrleitung (115) einen Einlassteil (110) umfasst, der zur Erhöhung der Gasgeschwindigkeit ausgelegt ist;
**gekennzeichnet dadurch, dass** der Einlassteil (110) einen röhrenförmigen Teil (112) mit einem geringeren Innendurchmesser als die Zufuhrleitung (115) umfasst.

2. Vorrichtung nach Anspruch 1, wobei der Einlassteil (110) einen röhrenförmigen Teil (112) umfasst, der chemisch inert ist.

3. Vorrichtung nach einem vorhergehenden Anspruch, wobei der Einlassteil (110) einen röhrenförmigen Teil (112) umfasst, der elektrisch isolierend ist.

4. Vorrichtung nach einem vorhergehenden Anspruch, wobei der Einlassteil (110) einen äußeren Teil oder ein äußeres Rohr (111) umfasst, in dem ein Innenrohr (112) untergebracht ist.

5. Vorrichtung nach einem vorhergehenden Anspruch, umfassend:
eine die Reaktionskammer (130) umgebende Vakuumkammer (140).

6. Vorrichtung nach einem vorhergehenden Anspruch, umfassend:
eine konvergierende Düse (112') oder eine konvergierend-divergierende Düse (112") zur Erhöhung der Gasgeschwindigkeit.

7. Vorrichtung nach einem vorhergehenden Anspruch, die dazu ausgelegt ist, sequenzielle selbstsättigende Oberflächenreaktionen auf einer Substratoberfläche in der Reaktionskammer (130) auszuführen.

8. Verfahren, umfassend:
Einführen von Plasmaspezien über eine Plasmazufuhrleitung (115) in eine Reaktionskammer (130) für ein Abscheidungsziel (160) in einer Substratverarbeitungsvorrichtung (100); und
Erhöhen der Gasgeschwindigkeit in der Plasmazufuhrleitung über einen Einlassteil (110), **gekennzeichnet dadurch, dass** der Einlassteil (110) einen röhrenförmigen Teil (112) mit einem kleineren Innendurchmesser als die Zufuhrleitung (115) umfasst.

9. Verfahren nach Anspruch 8, wobei der Einlassteil (110) einen röhrenförmigen Teil (112) umfasst, der chemisch inert ist.

10. Verfahren nach einem vorhergehenden Anspruch 8-9, wobei der Einlassteil (110) einen röhrenförmigen Teil (112) umfasst, der elektrisch isolierend ist.

11. Verfahren nach einem vorhergehenden Anspruch 8-10, wobei der Einlassteil (110) einen äußeren Teil oder ein äußeres Rohr (111) umfasst, in dem ein Innenrohr (112) untergebracht ist.

12. Verfahren nach einem vorhergehenden Anspruch 8-11, umfassend:
Umgeben der Reaktionskammer (130) mit einer Vakuumkammer (140).

13. Verfahren nach einem vorhergehenden Anspruch 8-12, umfassend:
Ausführen von sequenziellen selbstsättigenden Oberflächenreaktionen auf einer Substratoberfläche in der Reaktionskammer (130).

## Revendications

1. Dispositif de traitement de substrat (100) comprenant :
une chambre de réaction (130);
une ligne d'alimentation en plasma (115) pour introduire des espèces plasmatiques dans la chambre de réaction (130) pour une cible de dépôt (160), dans lequel
la ligne d'alimentation en plasma (115) comprend une partie entrée (110) configurée pour accélérer la vitesse de gaz;
**caractérisé en ce que** la partie entrée (110) comprend une partie tubulaire (112) avec un diamètre intérieur plus petit que la ligne d'alimentation (115).

2. Dispositif selon la revendication 1, dans lequel la partie entrée (110) comprend une partie tubulaire (112) qui est chimiquement inerte.

3. Dispositif selon une revendication précédente quelconque, dans lequel la partie entrée (110) comprend une partie tubulaire (112) qui est électriquement isolante.

4. Dispositif selon une revendication précédente quelconque, dans lequel la partie entrée (110) comprend une partie ou un tube extérieur(e) (111) logeant un tube intérieur (112).

5. Dispositif selon une revendication précédente quelconque, comprenant :
une chambre à vide (140) entourant la chambre de réaction (130).

6. Dispositif selon une revendication précédente quelconque, comprenant :
une buse convergente (112') ou une buse convergente-divergente (112") pour accélérer la vitesse de gaz.

7. Dispositif selon une revendication précédente quelconque, configuré pour effectuer des réactions en surface auto-saturantes séquentielles sur une surface de substrat dans la chambre de réaction (130).

8. Procédé comprenant les étapes consistant à :
introduire des espèces plasmatiques par une ligne d'alimentation en plasma (115) dans une chambre de réaction (130) pour une cible de dépôt (160) dans un dispositif de traitement de substrat (100); et
accélérer la vitesse de gaz dans la ligne d'alimentation en plasma par une partie entrée (110), **caractérisé en ce que** la partie entrée (110) comprend une partie tubulaire (112) avec un diamètre intérieur plus petit que la ligne d'alimentation (115).

9. Procédé selon la revendication 8, dans lequel la partie entrée (110) comprend une partie tubulaire (112) qui est chimiquement inerte.

10. Procédé selon l'une des revendications précédentes 8 à 9, dans lequel la partie entrée (110) comprend une partie tubulaire (112) qui est électriquement isolante.

11. Procédé selon l'une des revendications précédentes 8 à 10, dans lequel la partie entrée (110) comprend une partie ou un tube extérieur(e) (111) logeant un tube intérieur (112).

12. Procédé selon l'une des revendications précédentes 8 à 11, comprenant l'étape consistant à :
entourer d'une chambre à vide (140) la chambre de réaction (130).

13. Procédé selon l'une des revendications précédentes 8 à 12, comprenant l'étape consistant à :
effectuer des réactions en surface auto-saturantes séquentielles sur une surface de substrat dans la chambre de réaction (130).
